(19) Europäisches Patentamt
European Patent Office
Office européen des brevets

(11) **EP 4 328 947 A1**

(12) **EUROPEAN PATENT APPLICATION**
published in accordance with Art. 153(4) EPC

(43) Date of publication:
**28.02.2024 Bulletin 2024/09**

(21) Application number: **22880209.6**

(22) Date of filing: **09.10.2022**

(51) International Patent Classification (IPC):
**H01H 9/54** (2006.01)   **H01H 71/00** (2006.01)
**H01H 71/10** (2006.01)

(52) Cooperative Patent Classification (CPC):
**H01H 9/54; H01H 71/00; H01H 71/10**

(86) International application number:
**PCT/CN2022/123937**

(87) International publication number:
**WO 2023/061270 (20.04.2023 Gazette 2023/16)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **15.10.2021 CN 202111202979**

(71) Applicant: **SCHNEIDER ELECTRIC INDUSTRIES
SAS**
**92500 Rueil-Malmaison (FR)**

(72) Inventors:
• **DONG, Jihua**
 **Shanghai 201203 (CN)**
• **SHI, Ying**
 **Shanghai 201203 (CN)**
• **CHEN, Jiangang**
 **Shanghai 201203 (CN)**

(74) Representative: **Manitz Finsterwald
Patent- und Rechtsanwaltspartnerschaft mbB
Martin-Greif-Strasse 1
80336 München (DE)**

(54) **OVERLOAD PROTECTION METHOD FOR SOLID-STATE CIRCUIT BREAKER, SOLID-STATE CIRCUIT BREAKER, AND POWER DISTRIBUTION SYSTEM**

(57)     The present disclosure relates to an overload protection method for a solid-state circuit breaker. The method comprises: measuring the temperature of a power electronic switch in a solid-state circuit breaker; detecting the overload current flowing through the solid-state circuit breaker; determining, according to the temperature and the overload current, the overload tripping time of the solid-state circuit breaker; and disconnecting the power electronic switch after the tripping time has passed. In addition, the present disclosure also relates to a solid-state circuit breaker and a power distribution system.

S201 — measuring the temperature of the power electronic switch in the solid-state circuit breaker

S202 — detecting an overload current flowing through the solid-state circuit breaker

S203 — determining an overload trip time of the solid-state circuit breaker according to the temperature and the overload current

S204 — turning off the power electronic switch after the trip time.

Fig. 2

**Description**

TECHNICAL FIELD

The present disclosure relates to an overload protection method for a solid-state circuit breaker, a solid-state circuit breaker and a power distribution system.

BACKGROUND

A large number of circuit breakers need to be applied in the power grid system, especially in the distribution system. On the one hand, when the load or line is overloaded, short-circuited, leaked or other fails, the circuit breaker can disconnect the line within a specified time, thus ensuring the safety of the load and line. On the other hand, circuit breakers can be used as switches to switch on and off large-scale electrical equipment, such as motors.

Traditional circuit breakers include thermomagnetic circuit breakers and electronic circuit breakers. The thermomagnetic circuit breaker is purely mechanical. When the line is overloaded, the current passing through the thermomagnetic circuit breaker becomes larger, the thermal element in the thermomagnetic circuit breaker heats up and heats the bimetal which is composed of different metals and therefore has different thermal expansion coefficients. Therefore, when the temperature changes, the bimetal will deform and bend, and when the deformation and bending reach a certain degree, it will push the free trip mechanism to act, thus tripping the circuit breaker.

Based on the above-mentioned purely mechanical structure of the thermomagnetic circuit breaker, it needs a complicated design and accurate thermal adjustment process in the design and production stages. Because of the structure of the thermomagnetic circuit breaker, its action error about overload current will be relatively large, and even thermomagnetic circuit breakers of the same model can hardly guarantee the same trip time. In addition, after the thermomagnetic circuit breaker is disconnected, it needs to be manually closed to restore the power supply.

The electronic circuit breaker does not use mechanical structure to control the trip of the circuit breaker, but uses the current transformer to collect the current and compare it with the setting threshold. When the current exceeds the threshold, the electronic circuit breaker can send a signal to the electronic trip according to the setting trip delay time to perform the trip action.

The electronic circuit breaker can be designed in strict accordance with the overload trip curve specified by the national standard or the manufacturer, so that it can have accurate trip delay time for the corresponding overload current. However, the disadvantage of the existing electronic circuit breaker is that the influence of the environmental temperature on the load, the line and the circuit breaker itself cannot be considered. For example, if the environmental temperature is too high, the load, the circuit and the circuit breaker may be overheated or even damaged if they continue to trip at a predetermined threshold.

Under the background of vigorously developing the smart grid, intelligent circuit breaker equipment is essential. Intelligent circuit breaker equipment needs to meet the requirements of automatic opening and closing, and also can automatically adjust the appropriate overload trip time according to the influence of the overload current and the temperature.

SUMMARY

The present disclosure discloses an overload protection method for a solid-state circuit breaker, a solid-state circuit breaker and a power distribution system with the solid-state circuit breaker. According to the overload protection method and the solid-state circuit breaker of the present disclosure, not only according to the magnitude of the overload current but also according to the temperature, the overload trip time can be adjusted so that the protection of the loads, the lines and the circuit breaker itself can be improved.

The embodiment of the present disclosure provides an overload protection method for a solid-state circuit breaker, including measuring a temperature of a power electronic switch in a solid-state circuit breaker, detecting an overload current flowing through the solid-state circuit breaker, determining an overload trip time of the solid-state circuit breaker according to the temperature and the overload current, and switching off the power electronic switch after the trip time.

According to the embodiment of the present disclosure, determining the overload trip time of the solid-state circuit breaker according to the temperature and the overload current includes adjusting the predetermined setting current value of the solid-state circuit breaker according to the temperature, determining the relationship between the overload trip time and the overload current according to the adjusted setting current value, and determining the overload trip time according to the overload current and the relationship between the overload trip time and the overload current.

According to the embodiment of the present disclosure, adjusting the predetermined setting current value of the solid-state circuit breaker according to the temperature includes, in the case of an increase in the temperature, derating the predetermined setting current value of the solid-state circuit breaker according to the temperature, if the temperature is higher than a first threshold.

According to the embodiment of the present disclosure, adjusting the predetermined setting current value of the solid-state circuit breaker according to the temperature further includes after the temperature exceeds the first threshold, if the temperature is lower than the first threshold and higher than a second threshold, remaining the derated setting current value unchanged, and if the temperature is lower than the second threshold, restoring the derated setting current value to a predetermined setting current value.

According to the embodiment of the present disclosure, in the case of an increase in the temperature, derating the predetermined setting current value of the solid-state circuit breaker according to the temperature, if the temperature is higher than a first threshold, includes, adding an increment to the temperature, and derating a predetermined setting current value of the solid-state circuit breaker according to temperature after the increment, and/or adding a decrement to the predetermined setting current value, and derating based on the added decrement predetermined setting current value.

The embodiment of the present disclosure provides a solid-state circuit breaker, which includes a power electronic switch, a temperature measuring unit, a current detection unit, a processing unit and a driving unit. The power electronic switch is configured to switch on and off a line connected to the solid-state circuit breaker. The temperature measuring unit is configured to measure a temperature of a power electronic switch in the solid-state circuit breaker and transmit the corresponding temperature signal to a processing unit. The current detection unit is configured to detect an overload current flowing through the solid-state circuit breaker and transmit the corresponding overload current signal to a processing unit. The processing unit is configured to determine an overload trip time of the solid-state circuit breaker according to the temperature signal and the overload current signal and send a driving signal to the driving unit after the trip time. The driving unit is configured to switch off the power electronic switch according to the driving signal.

According to the embodiment of the present disclosure, wherein the processing unit adjusts a predetermined setting current value of the solid-state circuit breaker according to the temperature signal, and determines the relationship between the overload trip time and the overload current according to the adjusted setting current value.

According to the embodiment of the present disclosure, wherein in the case of an increase in the temperature, the processing unit derates a predetermined setting current value of the solid-state circuit breaker according to the value of the temperature signal, if the value of the temperature signal is higher than a first threshold.

According to the embodiment of the present disclosure, wherein after the value of the temperature signal exceeds the first threshold, if the temperature is lower than the first threshold and higher than a second threshold, the processing unit remains the derated setting current value unchanged, and if the value of the temperature signal is lower than the second threshold, the processing unit restores the derated setting current value to a predetermined setting current value.

The embodiment of the present disclosure provides a power distribution system including a plurality of the solid-state circuit breakers, wherein the adjusted setting current value of a solid-state circuit breaker closer to the power supply is greater than that of a solid-state circuit breaker closer to the load.

The embodiment of the present disclosure provides a multipole solid-state circuit breaker, which include a plurality of power electronic switches, a temperature measuring unit, a current detection unit, a processing unit and a driving unit. The plurality of power electronic switches is configured to switch on and off a plurality of lines connected to the solid-state circuit breaker. The temperature measuring unit is configured to measure the temperatures of a plurality of power electronic switches in the solid-state circuit breaker and transmit corresponding temperature signals to a processing unit. The current detection unit is configured to detect an overload current flowing through a plurality of lines of the solid-state circuit breaker and transmit corresponding overload current signals to a processing unit. The processing unit is configured to determine an overload trip time of the solid-state circuit breaker according to the temperature signal of the highest temperature among the temperatures and the overload current signal of the largest overload current among the overload currents, and send a driving signal to the driving unit after the trip time passes. The driving unit is configured to switch off the power electronic switches according to the driving signal.

According to the embodiment of the present disclosure, the processing unit adjusts a predetermined setting current value of the solid-state circuit breaker according to the temperature signal of the highest temperature among the temperatures, and determines the relationship between the overload trip time and the maximum overload current according to the adjusted setting current value.

The overload protection method for the solid-state circuit breaker and the solid-state circuit breaker according to the present disclosure can consider not only the magnitude of overload current, but also the influence of temperature on the power electronic switch in the solid-state circuit breaker when setting the overload trip time. For example, when the working temperature of the power electronic switch is also high under the influence of higher environmental temperature, the overload trip time can be shortened according to the method of the present disclosure, so that the trip can be performed more quickly, thus avoiding the damage to the load equipment, the lines and the solid-state circuit breaker itself caused by the combined action of high temperature and heat accumulation.

In addition, through the power distribution system with a plurality of solid-state circuit breakers according to the present disclosure, the hierarchical protection of load equipment can be realized, and in the case of overload, only the solid-state circuit breaker closest to the fault location acts, thus avoiding over-step tripping, thereby limiting the number of load equipment affected by the fault to the minimum.

BRIEF DESCRIPTION OF DRAWINGS

In order to explain the technical scheme of the embodiment of the present disclosure more clearly, the drawings needed in the description of the embodiment will be briefly introduced below. Obviously, the drawings in the following description are only some exemplary embodiments of the present disclosure, and other embodiments can be obtained according to these embodiments without creative work for those of ordinary skill in the art.

Fig. 1 shows a block diagram of a solid-state circuit breaker according to the embodiment of the present disclosure,
Fig. 2 shows a flowchart of an overload protection method for a solid-state circuit breaker according to the embodiment of the present disclosure,
Fig. 3 shows a three-dimensional relationship diagram of overload trip time with temperature and load current according to the embodiment of the present disclosure,
Fig. 4 shows a flowchart of an example method for determining an overload trip time of a solid-state circuit breaker according to the embodiment of the present disclosure,
Fig. 5 shows an adjustment surface diagram of a setting current value with respect to temperature according to the embodiment of the present disclosure,
Fig. 6 shows a flowchart of an example method for adjusting a predetermined setting current value of a solid-state circuit breaker according to the embodiment of the present disclosure,
Fig. 7 shows a structural schematic diagram of a power distribution system according to the embodiment of the present disclosure.

DETAILED DESCRIPTION

In order to make the objects, technical solutions and advantages of the present disclosure more obvious, exemplary embodiments according to the present disclosure will be described in detail below with reference to the accompanying drawings. Obviously, the described embodiment is only a part of the embodiment of the present disclosure, not all the embodiments of the present disclosure, and it should be understood that the present disclosure is not limited by the exemplary embodiments described here.

In the specification and the drawings, basically the same or similar method steps and elements are denoted by the same or similar reference numerals, and repeated descriptions of these method steps and elements will be omitted. Meanwhile, in the description of the present disclosure, the terms "first", "second" and so on are only used to distinguish descriptions, and cannot be understood as indicating or implying relative importance or ranking. In the embodiment of the present disclosure, unless otherwise specified, "connected" does not necessarily mean "directly connected" or "directly contacted", but only needs to be electrically connected.

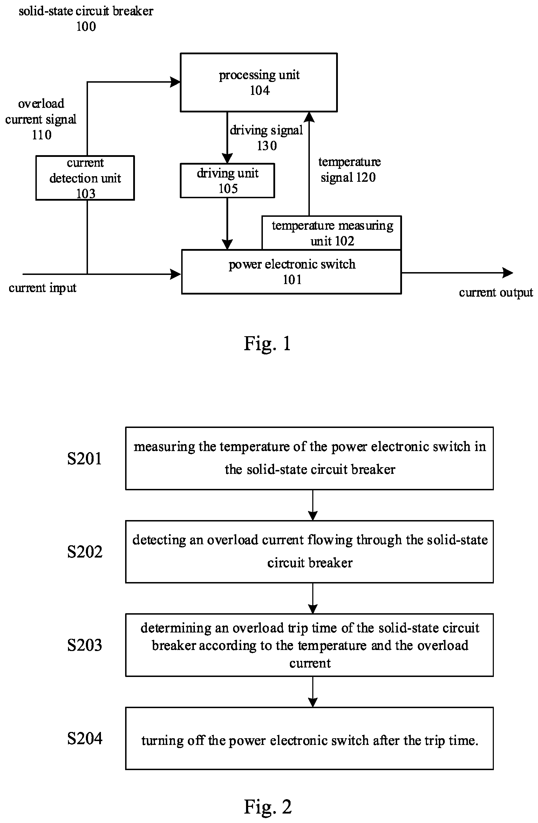

Fig. 1 shows a block diagram of a solid-state circuit breaker 100 according to the present disclosure. The solid-state circuit breaker 100 is different from the traditional thermomagnetic circuit breaker and electronic circuit breaker. It does not have mechanical moving parts, but uses high-power power electronic switches, such as MOSFET and IGBT, to switch on and off the current. Therefore, there are no contacts in the solid-state circuit breaker, so that there is no arc. In addition, the structure based on power electronic switches can control the solid-state circuit breaker more easily, so it is easier to realize the intelligentization of the circuit breaker. In Fig. 1, the solid-state circuit breaker 100 includes the power electronic switch 101 which is configured to switch on and off a line connected to the solid-state circuit breaker 100. In addition, the solid-state circuit breaker 100 also includes the temperature measuring unit 102 which is configured to measure a temperature of the power electronic switch 101 and transmit corresponding temperature signal to the processing unit 104; the current detection unit 103 which is configured to detect an overload current flowing through the solid-state circuit breaker 100, i.e. the power electronic switch 101, and transmit the corresponding overload current signal 110 to the processing unit 104; and the processing unit 104 which is configured to determine an overload trip time of the solid-state circuit breaker 100 according to the temperature signal 120 and the overload current signal 110 and send a driving signal 130 to the driving unit 105 after the trip time. The solid-state circuit breaker 100 further includes the driving unit 101 which is configured to switch off the power electronic switch according to the driving signal 130.

In the case of current overload, the solid-state circuit breaker according to the present disclosure can consider not only the magnitude of the overload current, but also the influence of temperature on the power electronic switch in the solid-state circuit breaker when setting the overload trip time. For example, when the working temperature of the power electronic switch is high, the overload trip time can be shortened, so that the trip can be performed more quickly, thus avoiding damage to the load equipment, the lines and the solid-state circuit breaker itself caused by the combined action of high temperature and heat accumulation.

Fig. 2 shows a flowchart of an overload protection method for a solid-state circuit breaker according to the embodiment of the present disclosure. The method includes the following steps: step S201: measuring the temperature of the power electronic switch 101 in the solid-state circuit breaker 100; step S202: detecting an overload current flowing through the solid-state circuit breaker 100; step S203: determining an overload trip time of the solid-state circuit breaker 100 according to the temperature and the overload current; and step S204: switching off the power electronic switch 101 after the trip time.

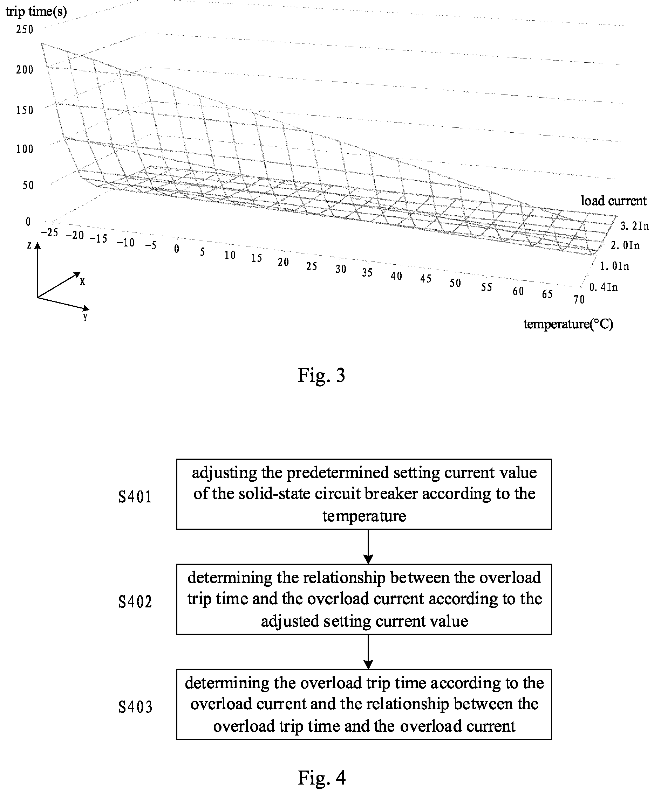

Fig. 3 exemplarily shows a three-dimensional relationship diagram of overload trip time with temperature and load current according to the embodiment of the present disclosure. When the method step S203 is executed to determine the overload trip time of the solid-state circuit breaker 100 according to the temperature and the overload current of the power electronic switch 101, the overload trip time of the solid-state circuit breaker 100 can be determined according to the measured temperature and the overload current of the power electronic switch 101 based on the three-dimensional relationship diagram.

In the three-dimensional diagram, the x-axis represents the load current flowing through the solid-state circuit breaker 100, wherein $I_n$ is the rated current value of the solid-state circuit breaker 100, the scale of the x-axis is the multiple of the rated current value, and when the load current exceeds the setting current value $I_r$ (the setting current value will be explained below which is usually 0.4-1 $I_n$), it is an overload current. The y-axis represents the temperature of the power electronic switch 101 in degrees Celsius (°C), and the z-axis represents the trip time of the solid-state circuit breaker 100 in degrees seconds (s). The three-dimensional relationship diagram can be obtained theoretically or experimentally according to the characteristics of the solid-state breaker.

As can be seen from Fig. 3, under the condition that the temperature of electronic switch 101 remains constant, with the increasement of the overload current, the trip time gradually decreases, which is called anti-time protection. When there is a large overload current or short circuit, the anti-time characteristic can make the solid-state circuit breaker open quickly, thus avoiding the damage of large current to the load equipment, the lines and the solid-state circuit breaker itself. On the contrary, when there is a small overload current, the solid-state circuit breaker can have a long trip time. On the one hand, the small overload current will not make the equipment, the lines and the solid-state circuit breaker itself heat up and cause damage quickly. On the other hand, if the overload current disappears within a long trip time, the solid-state circuit breaker may not be disconnected, thus avoiding the adverse effects caused by power outages.

Under the condition that the overload current remains constant, with the increase of the temperature of the power electronic switch 101, the trip time gradually decreases. Before the solid-state circuit breaker is disconnected, the overload current will make the load equipment, the lines and the solid-state circuit breaker itself heat up and form heat accumulation. For the load equipment and the lines, the heat accumulation will lead to overheating and thus increase losses, and even more seriously, the load equipment and the lines will fail or even be burned. For the solid-state circuit breakers, the thermal expansion coefficients of materials in different layers in their power electronic switches are different, so thermal stress between layers will occur at high temperature, which will lead to weld fatigue and bonding wire fracture. Therefore, reducing the trip time with the increase of the temperature can effectively reduce the heat accumulation and thus prevent the power electronic switch from overheating, so that avoiding the power electronic switch and the solid-state circuit breaker from being damaged.

In some implementations of the present disclosure, as shown in Fig. 4, the method step S203 may include the following method steps. The method step S401: adjusting the predetermined setting current value of the solid-state circuit breaker 100 according to the temperature; the method step S402: determining the relationship between the overload trip time and the overload current according to the adjusted setting current value; and the method step S403: determining the overload trip time according to the overload current and the relationship between the overload trip time and the overload current.

The setting current value $I_r$ of the solid-state circuit breaker 100 is also called the long delay setting current value. When the load current exceeds $I_r$, the solid-state circuit breaker 100 trips with delay, and $I_r$ therefore also indicates the maximum current that the solid-state circuit breaker 100 can withstand without tripping. The setting current value $I_r$ of the solid-state circuit breaker 100 must be greater than the load current $I_b$, but less than the maximum current allowed by the load equipment or the lines $I_z$. In practical application, the setting current value $I_r$ with appropriate magnitude can be preset according to the magnitude of $I_b$ and $I_z$, which is usually adjusted within the range of 0.4-1 $I_n$, wherein $I_n$ is the rated current value of the solid-state circuit breaker. For example, when the rated current value $I_n$ of the solid-state circuit breaker 100 is 100A and the load current $I_b$ is 60A, if the setting current value $I_r$ is set to 1 time of $I_n$, the sensitivity of protection is not enough, so the setting current value $I_r$ can be preset to 0.7 times of $I_n$, i.e. 70A. Therefore, the solid-state circuit breaker 100 is installed in the line with a preset (i.e., predetermined) setting current value $I_r$.

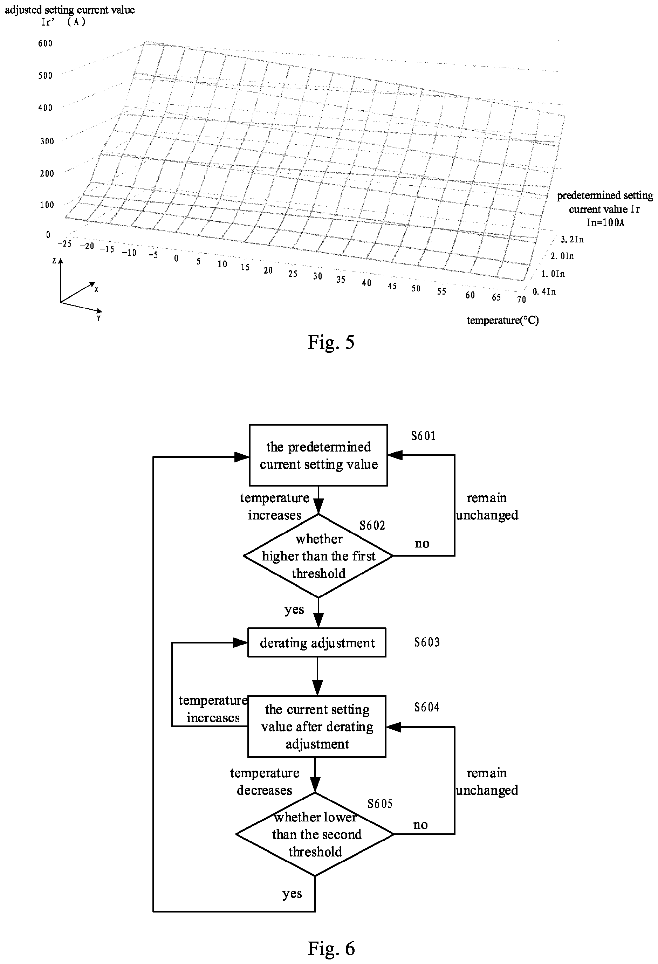

In the subsequent operation, the solid-state circuit breaker 100 can dynamically adjust the predetermined setting current value $I_r$ according to the temperature of the solid-state circuit breaker 100, by executing the method step S401. The temperature of the solid-state circuit breaker 100 can be, e.g., the surface temperature or the throttle temperature of the power electronic switch, which is influenced by the environmental temperature of the circuit breaker, the magnitude and time of the load current, etc. For example, the method step S401 can be performed with reference to the adjustment curve diagram of the setting current value $I_r$ with respect to the temperature shown in Fig. 5. In Fig. 5, the x-axis represents the predetermined setting current value $I_r$, wherein $I_n$ is the rated current value, shown here as 100A, and the scale of the x-axis is the multiple of the rated current value $I_n$. The y-axis represents the temperature of the power electronic switch 101 in degrees Celsius (°C), and the z-axis represents the adjusted setting current value $I_r'$ in degrees A. It is assumed that the temperature of the solid-state circuit breaker 100 in the normal operation state is 50°C. The predetermined setting current value $I_r$ will not be adjusted at this temperature. When the temperature is higher than 50°C, the setting current value can be gradually lowered with the increase of temperature. On the contrary, when the temperature is lower than 50°C, the setting current value can be gradually increased with the decrease of temperature. For example, the relationship between the adjusted setting current value $I_r'$ and the temperature $T$ and the predetermined setting current value $I_r$ can be described by the following formula.

$$I_r' = I_r \, (\mathrm{a} \cdot T + \mathrm{b}) \tag{1}$$

Wherein the coefficient a is negative and b is positive.

According to the adjusted setting current value $I_r'$, the relationship between the overload trip time and the overload current can be determined, e.g., given by the following formula.

$$I^2 T_1 = (c I_r')^2 T_r \tag{2}$$

Wherein $I$ represents the overload current, $T_1$ represents the overload trip time, $I_r'$ represents the adjusted setting current value, c is a constant, which usually takes a value in the range of 6 to 12, and $T_r$ represents the trip time setting value. The trip time setting value $T_r$ is a preset value according to the characteristics of the trip. Under the same other conditions, the greater the trip time setting value $T_r$, the longer the overload trip time.

After determining the relationship between the overload trip time $T_1$ and the overload current $I$ according to the adjusted setting current value $I_r'$, the corresponding overload trip time $T_1$ can be determined according to the detected overload current $I$, and the solid-state circuit breaker 100 will be disconnected after this overload trip time.

By combining the equations (1) and (2), the three-dimensional relationship diagram of the overload trip time $T_1$ with the temperature $T$ and the load current $I$ as shown in Fig. 3 can be established. Formulas (1) and (2) and their parameters can be obtained theoretically or experimentally according to the characteristics of the solid-state circuit breaker.

According to an implementation of the present disclosure, the method step S401: adjusting the predetermined setting current value of the solid-state circuit breaker 100 according to the temperature may further include the following method step: derating the predetermined current setting value of the solid-state circuit breaker 100 according to the temperature, if the temperature is higher than a first threshold. By executing this method step, the derating adjustment of the current setting value can be avoided under the condition that the temperature increasement is not great, so that the solid-state circuit breaker can be prevented from being too sensitive for the temperature change.

According to an implementation of the present disclosure, in the case of fluctuation in the temperature of the power electronic switch 101 in the solid-state circuit breaker 100, the method step of derating the predetermined current setting value of the solid-state circuit breaker 100 according to the temperature, if the temperature is higher than the first threshold, may further include the following method steps: after the temperature exceeds the first threshold, if the temperature is lower than the first threshold and higher than a second threshold, the derated setting current value remains unchanged, and if the temperature is lower than the second threshold, the derated setting current value restores to a predetermined setting current value. The first threshold and the second threshold can be set according to application requirements.

Fig. 6 shows the method steps of an example method for adjusting a predetermined setting current value of a solid-state circuit breaker according to the embodiment of the present disclosure. Starting from the method step S601, the solid-state circuit breaker operates at the predetermined current setting value. If the temperature increases, the temperature is compared with the first threshold in step S602. If the temperature does not exceed the first threshold, the predetermined current setting value remains unchanged, and if the temperature exceeds the first threshold, step S603 is executed, wherein the predetermined current setting value is derated according to the temperature. The solid-state circuit breaker operates at the current setting value after derating adjustment. If the temperature continues to increase, the derating can be adjusted again according to the temperature. If the temperature decreases, the temperature is compared with a second threshold in step S605. If the temperature is not lower than the second threshold, the derated current setting value remains unchanged, and if the temperature is lower than the second threshold, the derated current setting value is restored to a predetermined current setting value.

When the environmental temperature fluctuates violently and the operating temperature of the solid-state circuit breaker fluctuates constantly, the current setting value can be avoided to be adjusted frequently by setting the second threshold, thus preventing the solid-state circuit breaker from being switched off and on frequently. In this way, the load equipment can be supplied with power more smoothly, and the life of the solid-state circuit breaker can be extended by reducing the times of switching on and off.

According to an implementation of the present disclosure, in the case of an increase in the temperature of the power electronic switch 101 in the solid-state circuit breaker 100, derating the predetermined current setting value of the solid-state circuit breaker according to the temperature, if the temperature is higher than a first threshold, may include: adding an increment to the temperature, and derating a predetermined current setting value of the solid-state circuit breaker according to the temperature after the increment, and/or adding a decrement to the predetermined current setting value, and derating based on the added decrement predetermined current setting value

Under harsh working conditions, the temperature of the power electronic switch in the solid-state circuit breaker will continue to increase due to the environmental influence. In this case, in order to protect the power electronic switch, the solid-state circuit breaker needs to stop working quickly, i.e. to disconnect. According to the relationship between the overload trip time $T_1$ and the overload current I given by Formula (2), the predetermined current setting value can be greatly derated in order to reduce the trip time T1. Therefore, the predetermined current setting value can be derated under the condition of adding an increment to the measured temperature of the power electronic switch 101 and/or adding a decrement to t the predetermined current setting value.

Referring to the adjustment curve diagram of the setting current value with respect to the temperature shown in Fig. 5, e.g., if the predetermined current setting value is 1 $I_n$ and the temperature is 65°C, the corresponding derated current setting value at this coordinate position is 90A. If the predetermined current setting value needs to be derated greatly, the adjusted current setting value can be selected at a larger temperature coordinate and/or a smaller current setting value coordinate, e.g., selecting the predetermined current setting value which is 0.4 $I_n$, and the temperature is 70°C, the corresponding derated current setting value at this coordinate position is 50A.

Based on the current setting value after large derating adjustment, the solid-state circuit breaker can have a shorter overload trip time. Therefore, the solid-state circuit breaker can stop working more quickly, thus avoiding the damage of high temperature to the solid-state circuit breaker and the power electronic switch in it when the environmental temperature continues to increase.

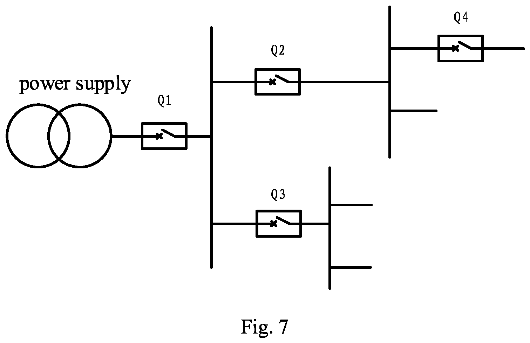

Fig. 7 shows a power distribution system according to the present disclosure. The power distribution system includes a plurality of the solid-state circuit breakers Q1-Q4 according to the embodiment of the present disclosure, wherein the adjusted current setting value of a solid-state circuit breaker closer to the power supply is greater than that of a solid-state circuit breaker closer to the load, i.e. $I'_{r,Q1} > I'_{r,Q3}$, and $I'_{r,Q1} > I'_{r,Q2} > I'_{r,Q4}$.

By designing the adjusted current setting value of the solid-state circuit breaker in this manner, it can be realized that only the solid-state circuit breaker which is closest to the fault location will act in the case of overload, thus the over-step tripping will be avoided so that limiting the number of load devices affected by the fault to the minimum.

The embodiment of the present disclosure provides a multipole solid-state circuit breaker, including a plurality of power electronic switches for switching on and off a plurality of lines connected to the solid-state circuit breaker, a temperature measuring unit which is configured to measure the temperatures of a plurality of power electronic switches in the solid-state circuit breaker and transmit corresponding temperature signals to a processing unit, a current detection unit which is configured to detect an overload currents flowing through a plurality of lines of the solid-state circuit breaker and transmit corresponding overload current signals to a processing unit, the processing unit which is configured to determine overload trip time of the solid-state circuit breaker according to the temperature signal of the highest temperature among the temperatures and the overload current signal of the largest overload current among the overload currents, and sending a driving signal to the driving unit after the trip time passes, and a driving unit which is configured to switch off the plurality of power electronic switches according to the driving signal.

According to the embodiment of the present disclosure, the processing unit adjusts a predetermined setting current value of the solid-state circuit breaker according to the temperature signal of the highest temperature among the temperatures, and determines the relationship between the overload trip time and the maximum overload current according to the adjusted setting current value.

The multipole solid-state circuit breaker can be, e.g., a three-pole circuit breaker or a four-pole circuit breaker. For the three-pole circuit breaker, it is connected to three phase lines of the power supply line and has three power electronic switches to disconnect the three phase lines when overload current occurs. For the four-pole circuit breaker, it is connected to three phase lines and the neutral line of the power supply line and has four power electronic switches to disconnect the three phase lines and the neutral line when overload current occurs.

The block diagrams of the circuits, units, devices, apparatus, equipment and systems involved in this disclosure are intended as exemplary examples only and are not intended to require or imply that they must be connected, arranged, configured in the manner illustrated in the block diagrams. As will be recognized by those skilled in the art, these circuits, units, devices, apparatus, equipment, systems may be connected, arranged, configured in any way, as long as the desired purpose can be achieved. The circuits, units, devices, apparatus involved in this disclosure can be realized in any suitable way, such as adopting application specific integrated circuits, field programmable gate arrays (FPGA) and so on, and can also be realized by combining a general processor with a program.

**Claims**

1. An overload protection method for a solid-state circuit breaker, comprising:

   Measuring a temperature of a power electronic switch in a solid-state circuit breaker,
   Detecting an overload current flowing through the solid-state circuit breaker,
   Determining an overload trip time of the solid-state circuit breaker according to the temperature and the overload current, and
   Switching off the power electronic switch after the trip time.

2. The overload protection method according to claim 1, wherein determining the overload trip time of the solid-state circuit breaker according to the temperature and the overload current comprises:

   Adjusting the predetermined setting current value of the solid-state circuit breaker according to the temperature,
   Determining the relationship between the overload trip time and the overload current according to the adjusted setting current value, and
   Determining the overload trip time according to the overload current and the relationship between the overload trip time and the overload current.

3. The overload protection method according to claim 2, wherein adjusting the predetermined setting current value of the solid-state circuit breaker according to the temperature comprises:
   In the case of an increase in the temperature, derating the predetermined setting current value of the solid-state circuit breaker according to the temperature, if the temperature is higher than a first threshold.

4. The overload protection method according to claim 3, wherein adjusting the predetermined setting current value of the solid-state circuit breaker according to the temperature further comprises:
   After the temperature exceeds the first threshold, if the temperature is lower than the first threshold and higher than a second threshold, remaining the derated setting current value unchanged, and if the temperature is lower than the second threshold, restoring the derated setting current value to a predetermined setting current value.

5. The overload protection method according to claim 3, wherein in the case of an increase in the temperature, derating the predetermined setting current value of the solid-state circuit breaker according to the temperature, if the temperature is higher than a first threshold, comprises:

   Adding an increment to the temperature, and derating a predetermined setting current value of the solid-state circuit breaker according to the temperature after the increment, and/or
   Adding a decrement to the predetermined setting current value, and derating based on the added decrement predetermined setting current value.

6. A solid-state circuit breaker, comprising:

   A power electronic switch which is configured to switch on and off a line connected to the solid-state circuit breaker,
   A temperature measuring unit which is configured to measure a temperature of a power electronic switch in the solid-state circuit breaker and transmit the corresponding temperature signal to a processing unit,
   A current detection unit which is configured to detect an overload current flowing through the solid-state circuit breaker and transmit the corresponding overload current signal to a processing unit,
   The processing unit which is configured to determine an overload trip time of the solid-state circuit breaker according to the temperature signal and the overload current signal and send a driving signal to the driving unit after the trip time, and

A driving unit which is configured to switch off the power electronic switch according to the driving signal.

7.  The solid-state circuit breaker according to claim 6, wherein
    The processing unit adjusts a predetermined setting current value of the solid-state circuit breaker according to the temperature signal, and determines the relationship between the overload trip time and the overload current according to the adjusted setting current value.

8.  The solid-state circuit breaker according to claim 7, wherein,
    In the case of an increase in the temperature, the processing unit derates a predetermined setting current value of the solid-state circuit breaker according to the value of the temperature signal, if the value of the temperature signal is higher than a first threshold.

9.  The solid-state circuit breaker according to claim 8, wherein,
    After the value of the temperature signal exceeds the first threshold, if the temperature is lower than the first threshold and higher than a second threshold, the processing unit remains the derated setting current value unchanged, and if the value of the temperature signal is lower than the second threshold, the processing unit restores the derated setting current value to a predetermined setting current value.

10. A power distribution system comprising a plurality of the solid-state circuit breakers according to any one of claims 6 to 9, wherein
    The adjusted setting current value of a solid-state circuit breaker closer to the power supply is greater than that of a solid-state circuit breaker closer to the load.

11. A multipole solid-state circuit breaker, comprising:

    A plurality of power electronic switches which is configured to switch on and off a plurality of lines connected to the solid-state circuit breaker,
    A temperature measuring unit which is configured to measure the temperatures of a plurality of power electronic switches in the solid-state circuit breaker and transmit corresponding temperature signals to a processing unit,
    A current detection unit which is configured to detect an overload current flowing through a plurality of lines of the solid-state circuit breaker and transmit corresponding overload current signals to a processing unit,
    The processing unit which is configured to determine an overload trip time of the solid-state circuit breaker according to the temperature signal of the highest temperature among the temperatures and the overload current signal of the largest overload current among the overload currents, and send a driving signal to the driving unit after the trip time passes, and
    A driving unit which is configured to switch off the power electronic switches according to the driving signal.

12. The multipole solid-state circuit breaker according to claim 11, wherein
    The processing unit adjusts a predetermined setting current value of the solid-state circuit breaker according to the temperature signal of the highest temperature among the temperatures, and determines the relationship between the overload trip time and the maximum overload current according to the adjusted setting current value.

solid-state circuit breaker
100

```
                              ┌─────────────────┐
                    ┌────────→│ processing unit  │
                    │         │       104        │
                    │         └─────────────────┘
  overload          │              │         ↑
current signal      │         driving signal  │
    110             │              130        │
                    │              ↓     temperature
         ┌──────────────┐    ┌──────────┐   signal 120
         │   current    │    │ driving  │
         │detection unit│    │ unit     │
         │     103      │    │   105    │  ┌──────────────────┐
         └──────────────┘    └──────────┘  │temperature measuring│
               │                  │        │     unit 102      │
               │                  ↓        └──────────────────┘
               │         ┌──────────────────────┐
  ─────────────────────→│  power electronic switch │──────────→
current input            │          101           │   current output
                         └──────────────────────┘
```

Fig. 1

```
        ┌──────────────────────────────────────────────────┐
S201    │ measuring the temperature of the power electronic switch in │
        │          the solid-state circuit breaker          │
        └──────────────────────────────────────────────────┘
                              │
                              ↓
        ┌──────────────────────────────────────────────────┐
S202    │ detecting an overload current flowing through the solid-state │
        │                  circuit breaker                  │
        └──────────────────────────────────────────────────┘
                              │
                              ↓
        ┌──────────────────────────────────────────────────┐
S203    │ determining an overload trip time of the solid-state circuit │
        │   breaker according to the temperature and the overload │
        │                      current                      │
        └──────────────────────────────────────────────────┘
                              │
                              ↓
        ┌──────────────────────────────────────────────────┐
S204    │  turning off the power electronic switch after the trip time. │
        └──────────────────────────────────────────────────┘
```

Fig. 2

trip time(s)

load current

3. 2In

2. 0In

1. 0In

0. 4In

temperature(°C)

Fig. 3

| | | |
|---|---|---|
| S401 | adjusting the predetermined setting current value of the solid-state circuit breaker according to the temperature | |

| | | |
|---|---|---|
| S402 | determining the relationship between the overload trip time and the overload current according to the adjusted setting current value | |

| | | |
|---|---|---|
| S403 | determining the overload trip time according to the overload current and the relationship between the overload trip time and the overload current | |

Fig. 4

adjusted setting current value
Ir' （A）

Fig. 5

Fig. 6

Fig. 7

## INTERNATIONAL SEARCH REPORT

| International application No. |
| --- |
| **PCT/CN2022/123937** |

| A. CLASSIFICATION OF SUBJECT MATTER |
| --- |
| H01H 9/54(2006.01)i; H01H 71/00(2006.01)i; H01H 71/10(2006.01)i |
| According to International Patent Classification (IPC) or to both national classification and IPC |

| B. FIELDS SEARCHED |
| --- |
| Minimum documentation searched (classification system followed by classification symbols) |
| H01H |
| Documentation searched other than minimum documentation to the extent that such documents are included in the fields searched |
| Electronic data base consulted during the international search (name of data base and, where practicable, search terms used) |
| CNABS; CNTXT; CNKI; VEN; USTXT; EPTXT; WOTXT: 施耐德, 过载, 保护, 固态, 电子, 智能, 断路器, 开关, 遮断器, 温度, 温升, 时间, 时长, 时延, 延时, 脱扣, 断开, 电流, 过流, solid, electronic, Intelligent, breaker, switch, temperature, time, delay, trip+, disconnect, cut, break off, overload current, overcurrent, overload, protect+ |

| C. DOCUMENTS CONSIDERED TO BE RELEVANT |
| --- |

| Category* | Citation of document, with indication, where appropriate, of the relevant passages | Relevant to claim No. |
| --- | --- | --- |
| A | CN 112886533 A (CANGZHOU SANZHENG ELECTRONICS CO., LTD.) 01 June 2021 (2021-06-01) description, paragraphs [0049]-[0092], and figures 1-8 | 1-12 |
| A | CN 213519831 U (CHANGSHU SWITCHGEAR MFG. CO., LTD. (FORMER CHANGSHU SWITCHGEAR PLANT)) 22 June 2021 (2021-06-22) entire document | 1-12 |
| A | CN 101039021 A (XI'AN JIAOTONG UNIVERSITY) 19 September 2007 (2007-09-19) entire document | 1-12 |
| A | US 2021126447 A1 (ATOM POWER INC.) 29 April 2021 (2021-04-29) entire document | 1-12 |

| ☐ Further documents are listed in the continuation of Box C. | ☑ See patent family annex. |
| --- | --- |

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| **21 November 2022** | **07 December 2022** |

| Name and mailing address of the ISA/CN | Authorized officer |
| --- | --- |
| **China National Intellectual Property Administration (ISA/CN)** **No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

**INTERNATIONAL SEARCH REPORT**
Information on patent family members

International application No.

**PCT/CN2022/123937**

| Patent document cited in search report | | | Publication date (day/month/year) | Patent family member(s) | | | Publication date (day/month/year) |
|---|---|---|---|---|---|---|---|
| CN | 112886533 | A | 01 June 2021 | CN | 214412261 | U | 15 October 2021 |
| CN | 213519831 | U | 22 June 2021 | None | | | |
| CN | 101039021 | A | 19 September 2007 | CN | 100530877 | C | 19 August 2009 |
| US | 2021126447 | A1 | 29 April 2021 | None | | | |

Form PCT/ISA/210 (patent family annex) (January 2015)